# FASCICULE DE BREVET EUROPEEN

(11) **EP 0 898 307 B1**
(45) Date de publication et mention de la délivrance du brevet: **27.12.2006**
(21) Numéro de dépôt: 98402073.5
(22) Date de dépôt: 17.08.1998
(51) Int. Cl.: H01L 21/68, H01L 21/603

(54) **Procédé de traitement pour le collage moléculaire et le décollage de deux structures**
Behandlungsverfahren zum Molekularkleben und Ablösen von zwei Strukturen
Method of treatment for molecular gluing and ungluing of two structures

(30) Priorité: 19.08.1997 FR 9710480
(43) Date de publication de la demande: 24.02.1999
(73) Titulaire: COMMISSARIAT A L'ENERGIE ATOMIQUE, 75015 Paris (FR)
(72) Inventeur: Maleville, Christophe, 38190 Bernin (FR); Aspar, Bernard, 38140 Rives (FR)
(74) Mandataire: Poulin, Gérard

(56) Documents cités:
- EP-A- 0 751 556
- WO-A-94/17551
- FR-A- 2 501 907
- MASZARA W P ET AL: "BONDING OF SILICON WAFERS FOR SILICON-ON-INSULATOR" JOURNAL OF APPLIED PHYSICS, vol. 64, no. 10, PART 1, 15 novembre 1988, pages 4943-4950, XP000050002

## Description

### Domaine technique

La présente invention concerne un procédé de traitement pour le collage par adhésion moléculaire et le décollage de deux structures.

On entend par structure toute pièce de micromécanique, d'optique intégrée, ou de microélectronique susceptible d'être associée à une autre pièce par collage. Une telle structure peut être, par exemple, un substrat ou une plaque de support équipés ou non de composants électroniques, optiques ou mécaniques.

Par ailleurs, le collage par adhésion moléculaire est compris comme un collage qui met en oeuvre une interaction entre les terminaisons chimiques présentes sur les surfaces des structures mises en contact.

L'invention trouve des applications notamment dans la fabrication de dispositifs à circuits intégrés. En effet, dans certains procédés de fabrication, les plaquettes de semi-conducteur contenant des circuits intégrés doivent être solidarisées avec des substrats de rigidité, puis désolidarisées en fin de traitement.

### Etat de la technique antérieure

Comme évoqué ci-dessus, et en particulier dans des applications de microélectronique concernant la fabrication de circuits de puissance, les tranches de semi-conducteur comportant des circuits électroniques intégrés se présentent sous la forme de plaquettes minces et de grandes dimensions. A titre d'exemple, on utilise des plaquettes d'un diamètre de quatre pouces (~10cm) avec une épaisseur inférieure à 200 µm.

Les équipements standards de fabrication de dispositifs de microélectronique, tels que les photorépéteurs par exemple, ne sont pas adaptés au traitement de plaquettes aussi minces. De plus, les plaquettes de semi-conducteur minces présentent une grande fragilité. Cette fragilité est difficilement compatible avec des étapes de manipulation, et notamment de manipulation par des équipements de traitement automatisés.

Une plaquette mince ou une couche superficielle d'un substrat comportant ou non des circuits intégrés peut être collée sur un support de traitement encore appelé "substrat poignée". Le substrat poignée lui confère alors une résistance mécanique suffisante pour tous les traitements et manipulations envisagés.

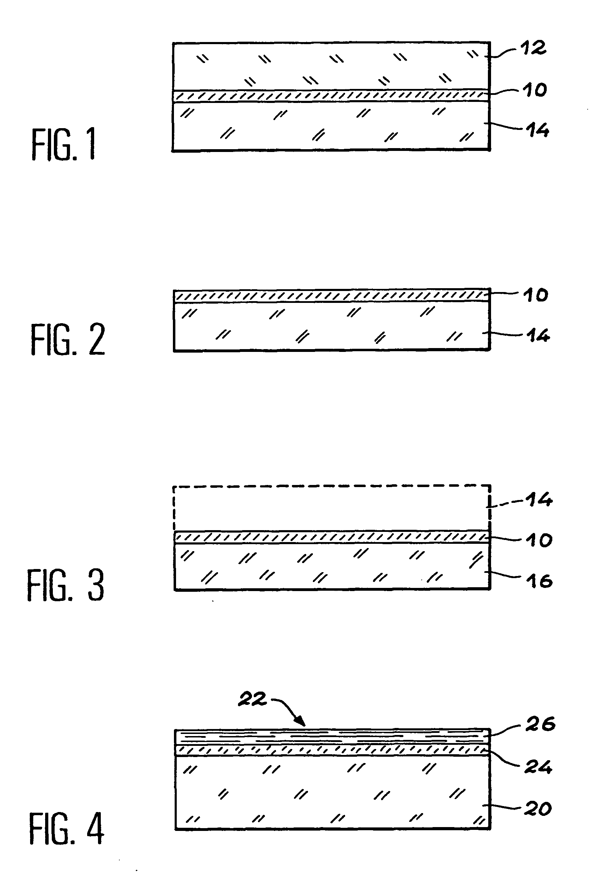

Les figures 1 à 3 annexées, décrites ci-après, illustrent à titre d'exemple un transfert d'une couche mince comprenant des circuits intégrés.

La couche mince, repérée avec la référence 10 sur la figure 1, est initialement solidaire d'un substrat 12, dit substrat d'origine. Elle comporte des composants et des circuits électroniques intégrés non représentés.

Le substrat d'origine 12 et la couche mince superficielle 10 sont reportés sur un substrat poignée 14 en collant la couche mince superficielle sur le substrat poignée. La structure ainsi obtenue est représentée à la figure 1.

Le substrat d'origine est ensuite éliminé par un procédé tel que la rectification ou le clivage, par attaque chimique et/ou par polissage pour obtenir la structure de la figure 2.

La couche mince 10 comprenant les circuits intégrés, est désormais collée, à l'envers, sur le substrat poignée 14. Le substrat poignée confère ainsi à cette couche la rigidité nécessaire pour d'autres opérations ou traitements de fabrication.

Dans une dernière étape, représentée à la figure 3, la couche mince 10 contenant les circuits électroniques est transférée vers un substrat cible ou substrat de destination 16 sur lequel elle est définitivement fixée.

Après la fixation sur le substrat de destination 16, la couche mince 10 est séparée du substrat poignée 14. Aussi, le substrat poignée 14 est représenté en trait discontinu sur la figure 3.

Un tel procédé est décrit de façon plus détaillée dans le document (1) dont la référence est indiquée à la fin de la présente description.

Le collage de la couche mince 10 sur le substrat poignée 14 peut être effectué, par exemple, à froid au moyen d'une colle appropriée. Le collage est alors réversible et la séparation de la couche mince 10 du substrat poignée est possible. Toutefois, l'adhésion obtenue entre la couche mince 10 et le substrat poignée 14 peut être insuffisante, notamment pour des traitements ultérieurs à haute température. En particulier, la colle n'est pas capable de supporter des températures élevées.

De plus, la matière (colle) ajoutée pour le collage risque de provoquer une contamination métallique ou organique des pièces collées lors de traitements ultérieurs.

Pour éviter ces inconvénients, on privilégie le collage par adhésion moléculaire qui ne met pas en oeuvre de colle ou de matière ajoutée. Le collage par adhésion moléculaire entre deux structures comporte pour l'essentiel quatre étapes qui sont indiquées ci-après.

Une première étape comporte la préparation des surfaces des structures destinées à être mises en contact. L'obtention d'un collage moléculaire de qualité nécessite le contrôle de paramètres importants tels que la rugosité des surfaces, qui doit être de préférence inférieure à 0,5 nm (5Å), en valeur quadratique moyenne, l'absence de poussières (particules >0,2µm) sur les surfaces, la planéité des surfaces à mettre en contact et l'état chimique de ces surfaces.

La première étape comporte ainsi, pour l'essentiel, un nettoyage des surfaces des structures à coller afin d'en éliminer les particules étrangères et de rendre ces surfaces hydrophiles.

La figure 4 montre une structure pour le collage comportant un substrat de silicium 20 dont on a rendu une surface 22 hydrophile. La surface 22 présente une première couche hydrophile 24 constituée pour l'essentiel de groupes chimiques Si-OH et une (ou plusieurs) couche d'eau H₂O 26 adsorbée sur la couche hydrophile 24.

Une deuxième étape comporte la mise en contact des surfaces hydrophiles des deux structures à coller. Cette mise en contact permet de rapprocher suffisamment les couches d'eau adsorbées sur les structures pour que celles-ci entrent en interaction. L'attraction qui s'exerce entre les molécules d'eau se propage de proche en proche sur l'ensemble de la surface de chaque structure. Les surfaces en contact sont alors collées dans leur ensemble.

La mesure de l'énergie du collage par une méthode d'insertion de lame donne une valeur de l'ordre de 0,15 J/m². Une telle valeur est typiquement celle d'une adhésion de type hydrogène entre les deux couches d'eau, respectivement de chaque structure.

Le document (2) dont la référence est indiquée à la fin de la présente description est cité comme une illustration de la méthode d'insertion de lame.

Une troisième étape comporte un traitement thermique de solidification de l'adhésion.

Le traitement thermique permet, jusqu'à une température de l'ordre de 200°C, d'éliminer les couches d'eau entre les structures assemblées.

L'adhésion des structures a alors lieu par des liaisons de groupes OH, entre les couches de groupes chimiques Si-OH respectivement de chaque structure. On rappelle que la couche de groupes Si-OH est indiquée avec la référence 24 sur la figure 4. De cette interaction résulte une diminution de la distance des deux structures en contact et la mise en interaction de groupes OH supplémentaires. L'énergie du collage augmente ainsi pour des températures de traitement de 200°C à 900°C.

Enfin, une éventuelle quatrième étape comprend un traitement thermique à plus de 900°C. Lors de cette étape, les groupes Si-OH en interaction évoluent vers des liaisons de type Si-O-Si, beaucoup plus fortes. On observe alors une très forte augmentation de l'énergie de liaison.

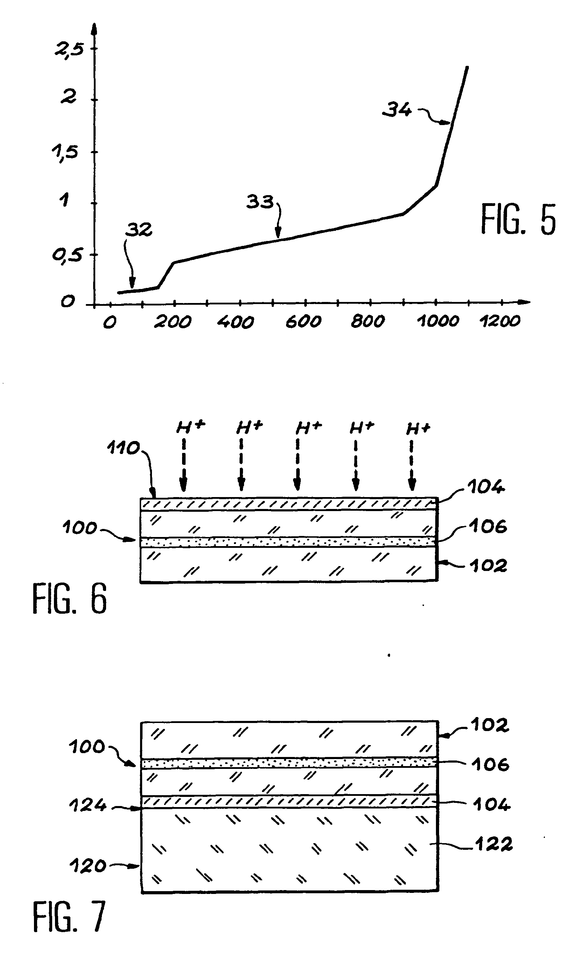

Le graphique de la figure 5 indique en ordonnée l'énergie de liaison par unité de surface, entre les structures collées par adhésion moléculaire, en fonction de la température de traitement. Les énergies de liaison sont exprimées en J/m² et les températures en °C.

Des régions 32, 33 et 34 de la courbe du graphique se rapportent aux deuxième, troisième et quatrième étapes du procédé de collage et correspondent respectivement à une interaction de type hydrogène entre les films d'eau, une interaction hydrogène entre groupes OH (référence 24) puis une interaction de type Si-O-Si. Une description plus détaillée du collage de plaquettes de silicium peut être trouvée dans le document (3) dont la référence est indiquée à la fin de la présente description.

On peut noter que pour des températures de traitement supérieures à 600°C, il devient impossible de redécoller les deux structures assemblées sans leur faire subir des dégradations importantes.

Lorsque les structures assemblées sont des plaquettes de silicium, des énergies de liaison supérieures à 2 J/m² peuvent être obtenues. Ces énergies sont ainsi de l'ordre de grandeur des énergies de cohésion du matériau silicium.

Il apparaît immédiatement que si un collage moléculaire est mis en oeuvre dans un procédé de transfert tel qu'illustré par les figures 1 à 3, il est impossible de détacher le substrat poignée de la couche mince par des forces mécaniques, sans détruire la couche mince ou le substrat poignée.

Ainsi, la séparation de la couche mince du substrat poignée a lieu par élimination du substrat poignée. Le substrat poignée est éliminé par exemple par rodage et/ou par abrasion mécano-chimique.

Dans ce cas, le procédé de transfert d'une couche mince nécessite le sacrifice d'un substrat poignée pour chaque couche mince traitée. Ce sacrifice représente également un coût industriel important.

### Exposé de l'invention

La présente invention a pour but de proposer un traitement pour le collage de deux structures permettant, non seulement d'obtenir un collage moléculaire très résistant des deux structures, mais permettant également de décoller les structures selon l'interface de collage.

Un but de l'invention est également de proposer un traitement permettant un décollage qui n'abîme pas les structures assemblées.

Pour atteindre ces buts, l'invention a plus précisément pour objet un procédé de traitement pour le collage de deux structures par adhésion moléculaire selon une interface de collage, et le décollage desdites deux structures selon ladite interface de collage.

Conformément à l'invention,
- on utilise, pour le collage, au moins une structure contenant au moins un élément susceptible de diffuser dans ladite structure vers l'interface de collage, et
- on effectue, pour le décollage, un traitement thermique avec un budget thermique suffisant pour faire diffuser ledit élément vers l'interface de collage pour la fragiliser.

On entend par élément susceptible de diffuser tout élément, simple ou composé, présent intrinsèquement ou incorporé, volontairement ou involontairement, dans le matériau, capable de migrer dans le matériau vers l'interface de collage, pour réagir avec celui-ci. Cet élément est alors apte à modifier cet interface au cours du traitement thermique et à conduire à la séparation des deux parties de part et d'autre de l'interface. Cette séparation peut être assistée par une phase gazeuse qui se forme éventuellement à l'interface au cours du traitement thermique.

Par ailleurs, on entend par budget thermique, la somme des traitements thermiques effectués et définis par un couple temps/température appliqué à la structure.

Ainsi, le traitement thermique apte à décoller les deux parties (de part et d'autre de l'interface de collage) peut tenir compte de traitements thermiques antérieurs au décollage subis par les structures assemblées.

Selon une mise en oeuvre particulière du procédé, on peut effectuer, avant le collage, une implantation d'hydrogène dans au moins l'une des structures, l'hydrogène formant ledit élément susceptible de diffuser dans la structure.

L'implantation est effectuée, par exemple, dans du silicium avec une dose comprise entre 10¹⁶ et 5.10¹⁶ (H⁺/cm²) et une énergie comprise entre 20 et 500 KeV. De préférence, la dose peut être de l'ordre de 3.10¹⁶ ions/cm² et l'énergie d'implantation de l'ordre de 70 KeV. La dose dépend des conditions d'implantation et en particulier de la température de la structure pendant l'implantation.

Selon une variante, on peut aussi utiliser au moins une structure comprenant une couche superficielle d'oxyde formée par un dépôt chimique en phase vapeur assisté par plasma et contenant des molécules OH, lesdites molécules OH formant l'élément susceptible de diffuser.

Le traitement thermique pour le décollage peut être effectué à une température comprise entre 600 et 1 350°C par exemple pour le silicium. Pour de l'arséniure de gallium (AₛGₐ) cette température est choisie plutôt de l'ordre de 200 à 600°C. Pour le carbure de silicium (SᵢC) la température est choisie de 600°C jusqu'à la température de fusion qui est supérieure à 1 350°C

Le traitement thermique peut avoir lieu, par exemple, sous des lampes de chauffage ou dans un four.

Les structures à assembler peuvent être des structures en un seul matériau massif mais peuvent aussi être des structures multicouches contenant des zones ayant été traitées ou pas.

Le caractère multicouche des structures peut avantageusement engendrer des contraintes internes qui favorisent la séparation des structures lors de l'étape de décollage.

De la même façon, on peut préparer, avant le collage, la surface d'au moins une des structures à assembler pour y pratiquer un relief. Ce relief permet également de faciliter la séparation des structures lors du décollage.

Enfin, pour favoriser encore le décollage, on peut exercer sur les structures des forces extérieures de séparation. Il s'agit, par exemple, de forces de traction ou de flexion exercées sur les structures ou encore des forces de cisaillement provoquées par l'insertion d'une lame au niveau de l'interface entre les structures.

D'autres caractéristiques et avantages de l'invention ressortiront mieux de la description qui va suivre, en référence aux figures des dessins annexés. Cette description est donnée à titre purement illustratif et non limitatif.

### Brève description des figures

- La figure 1, déjà décrite, est une coupe schématique d'une structure comprenant une couche mince sur un substrat, dit substrat d'origine, assemblée avec un autre substrat, dit substrat poignée.
- La figure 2, déjà décrite, est une coupe schématique du substrat poignée sur lequel est collée la couche mince.
- La figure 3, déjà décrite, est une coupe schématique de la couche mince reportée sur un substrat dit substrat de destination.
- La figure 4 est une coupe schématique d'une structure préparée pour un collage moléculaire.
- La figure 5 est un graphique exprimant l'énergie de liaison entre deux structures lors des étapes d'un collage moléculaire.
- La figure 6 est une coupe schématique d'une structure comprenant une plaquette de silicium et illustre la préparation de cette structure pour un collage moléculaire conforme à l'invention.
- La figure 7 montre en coupe la structure de la figure 6 collée sur une autre structure comprenant une plaquette de silicium.
- Les figures 8 et 9 montrent en coupe les structures assemblées de la figure 7, et illustrent une étape de traitement pour le décollage, conforme à l'invention.
- La figure 10 montre en coupe un autre assemblage obtenu par collage moléculaire de deux structures, conformément à l'invention.
- La figure 11 montre en coupe l'assemblage de la figure 10 lors d'un traitement pour le décollage, conformément à l'invention.

### Description détaillée de modes de mise en oeuvre de l'invention

La figure 6 montre une structure 100 destinée à un collage par adhésion moléculaire conforme à l'invention.

La structure 100 comporte une plaque de silicium 102 recouverte d'une couche d'oxyde de silicium superficielle 104.

Une couche d'hydrogène 106 implantée, est formée par implantation d'ions hydrogène dans la plaque de silicium 102 à travers la couche d'oxyde 104. La couche d'hydrogène, implantée à une énergie de l'ordre de 70 KeV, présente, dans cet exemple, une concentration de 3.10¹⁶ ions/cm², une épaisseur de 400 nm et est enterrée à une profondeur de l'ordre de 300 nm sous la surface supérieure 110 de la structure 100. (Les figures ne sont pas à l'échelle et ne respectent pas ces proportions).

Par hydrogène, on entend les espèces gazeuses constituées soit sous leur forme atomique (par exemple H) ou sous leur forme moléculaire (par exemple H₂) ou sous leur forme ionique (H⁺, H₂⁺, ...) ou sous leur forme isotopique (Deutérium) ou isotopique et ionique.

Si nécessaire, la surface 110 de la structure 100 est ensuite nettoyée afin de la rendre hydrophile et exempte de particules. Un film d'eau (non représenté sur la figure) est formé sur la surface 110.

Une faible rugosité peut également être conférée ou conservée à la surface 110 de la structure 100.

Comme le montre la figure 7, la structure 100 est ensuite assemblée avec une deuxième structure 120. La deuxième structure comporte une plaque de silicium 122, dont la surface en contact avec la structure 100, a également avantageusement subi un nettoyage pour la rendre hydrophile.

La référence 124 désigne l'interface entre les structures 100 et 120 assemblées.

Les structures subissent ensuite un premier recuit à une température de l'ordre de 500°C qui permet d'éliminer les couches d'eau entre les structures assemblées et qui permet d'établir des liaisons moléculaires entre les surfaces en contact.

L'énergie de liaison du collage moléculaire obtenu à 500°C est de l'ordre de 0,5J/m². Une telle énergie de liaison est suffisante, par exemple, pour relier une plaquette de silicium contenant des circuits intégrés à un substrat poignée ; elle est notamment suffisante pour l'ensemble des traitements envisagés pour la plaquette dans les équipements usuels de fabrication de dispositifs de microélectronique.

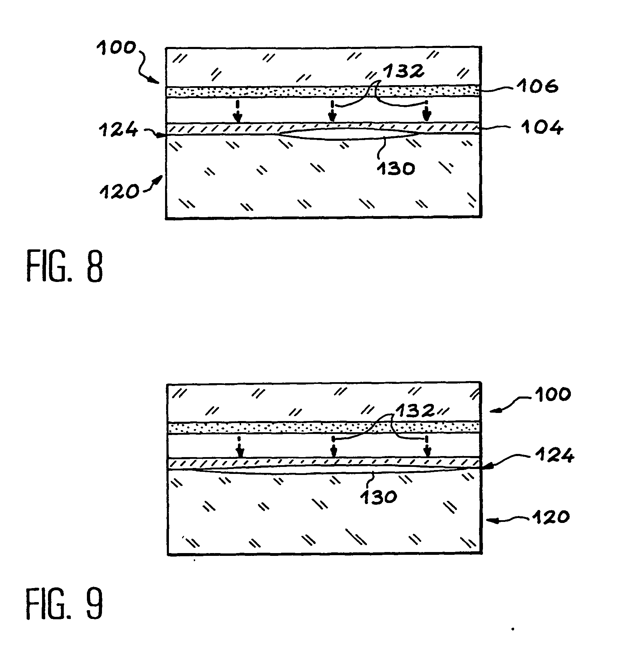

Lorsqu'on prolonge le traitement thermique ou lorsqu'on effectue un nouveau traitement thermique à une température de l'ordre de 800°C, ou plus, des zones de décollement, indiquées avec la référence 130 sur les figures 8 et 9, apparaissent au niveau de l'interface 124 entre les structures 100 et 120 assemblées.

La formation des zones de décollement est contrôlée par le budget thermique appliqué aux structures. En effet, le traitement thermique permet de faire diffuser l'hydrogène de la couche 106 implantée dans la structure 100 vers l'interface 124 de collage. (Par l'intermédiaire de l'oxyde s'il est présent). L'hydrogène qui diffuse est piégé au niveau de l'interface 124, s'y accumule et peut y évoluer sous forme gazeuse. Ainsi, l'accumulation de l'hydrogène à l'interface 124 permet de contrecarrer, au moins en partie, les forces de collage. Sur les figures 8 et 9 la diffusion de l'hydrogène vers l'interface 124 de collage est indiquée par des flèches 132.

Selon l'importance du budget thermique mis en oeuvre, les zones de décollement 130 peuvent être locales (figure 8) ou s'étendre sur l'ensemble de la surface de l'interface (figure 9).

Le budget thermique nécessaire à l'obtention du décollement complet dépend de la quantité de l'élément susceptible de migrer présent dans le matériau d'au moins l'une des structures. Dans le présent exemple, le budget thermique est par conséquent lié à la dose d'implantation de l'hydrogène. A titre d'exemple pour une dose de 3.16⁶ cm³ le budget peut être de 900°C -30 min.

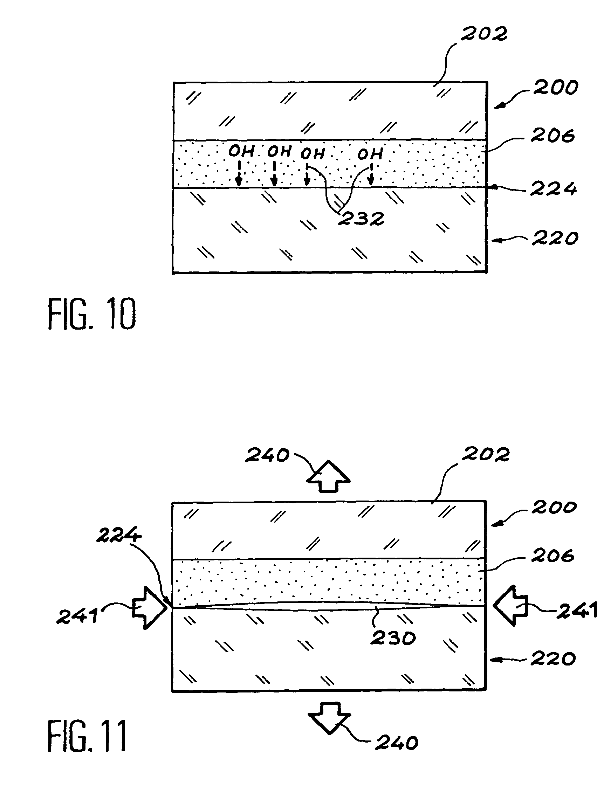

La figure 10 indique un autre exemple de mise en oeuvre de l'invention. Elle représente en coupe un assemblage d'une première structure 200 et d'une deuxième structure 220 qui sont collées par un collage moléculaire tel que décrit précédemment. La référence 224 désigne l'interface de collage entre les surfaces des structures assemblées.

La première structure comporte pour l'essentiel une plaque de silicium 202 à la surface de laquelle on a formé une couche 206 d'oxyde. L'oxyde de la couche 206 est déposé par une technique de dépôt par voie chimique en phase vapeur, assistée par plasma (Plasma Enhanced Chemical Vapor Deposition). Un tel oxyde a la particularité de contenir des molécules OH susceptibles de diffuser.

Un premier traitement thermique, effectué à une température inférieure ou égale à environ 500°C permet d'augmenter l'énergie du collage moléculaire.

Lorsque le traitement thermique est poursuivi ou repris à des températures supérieures à 500°C environ, les groupes OH contenus dans la couche d'oxyde 206 diffusent et migrent, notamment vers l'interface 224 ou ils sont piégés. La diffusion des groupes OH vers l'interface est indiquée avec des flèches 232.

A l'interface 224, les molécules OH évoluent sous forme gazeuse et se concentrent au niveau de l'interface de collage. Ce phénomène entraîne la formation de bulles et induit une fragilisation de l'interface de collage.

Sous l'effet d'une pression générée par le gaz, une zone décollée 230, représentée à la figure 11, se propage jusqu'au décollement complet des deux structures 200 et 220. La séparation des structures peut être facilité par l'exercice de forces mécaniques de séparation extérieures. Ces forces sont représentées par des flèches 240, 241 sur la figure 11. Les forces sont des forces de traction 240 et/ou des forces de cisaillement 241.

Il apparaît ainsi que le procédé de l'invention peut être notamment mis à profit pour le collage moléculaire de plaquettes de circuits intégrés, sans ajout de matière, tout en autorisant une réversibilité du collage.

Par ailleurs, l'invention s'applique à tout type de structure tel que défini précédemment. Il convient de préciser que l'invention ne concerne pas uniquement des structures comportant du silicium mais aussi d'autres structures semi-conductrices (Sᵢ, SᵢC, AₛGₐ....), des structures isolantes (verre, quartz...) ou même des structures conductrices (alliages métalliques...).

### DOCUMENT CITES

***(1)***
   FR-A-2 744 285
***(2)***
   "Bonding of silicon wafers for silicon-on-insulator" W.P. Maszara, G. Goetz, A. Caviglia and J.B. McKitterick
   Aerospace Technology Center, Allied Signal Aerospace Company, Columbia, Maryland 21045 (Received 12 April 1988, accepted for publication 28 July 1988).
***(3)***
   "A model for the silicon wafer bonding process"
   R. Stengl, T. Tan and U. Gösele
   School of Engineering, Duke University, Durham, North Carolina 27706, USA
   (Received May 8, 1989, accepted for publication July 15, 1989).
   Japanese Journal of Applied Physics, vol. 28, N°10, October 1989, pp. 1735-1741.

## Revendications

1. Procédé de traitement pour le collage de deux structures (100, 120, 200, 220), par adhésion moléculaire, selon une interface de collage (124, 224), et le décollage desdites deux structures selon ladite interface de collage, **caractérisé en ce que**
- on utilise pour le collage au moins une desdites deux structures (100, 200) contenant au moins un élément susceptible de diffuser dans ladite structure vers l'interface de collage,
- on effectue, pour le décollage, un traitement thermique avec un budget thermique suffisant pour faire diffuser ledit élément vers l'interface de collage (124, 224), pour la fragiliser.

2. Procédé selon la revendication 1, dans lequel avant le collage on effectue une implantation d'hydrogène dans au moins l'une des structures (100), l'hydrogène formant ledit élément susceptible de diffuser dans la structure.

3. Procédé selon la revendication 2, dans lequel l'implantation est effectuée dans du silicium avec une dose comprise entre 10¹⁶ et 5.10¹⁶ et une énergie comprise entre 20 et 500 KeV.

4. Procédé selon la revendication 1, dans lequel on utilise au moins une structure (200) comprenant une couche superficielle (206) d'oxyde formée par un dépôt chimique en phase vapeur assisté par plasma et contenant des molécules OH, lesdites molécules OH formant l'élément susceptible de diffuser.

5. Procédé selon la revendication 3, dans lequel le traitement thermique est effectué à une température comprise entre 600 et 1350°C.

6. Procédé selon la revendication 1, dans lequel le traitement thermique est effectué en exposant les structures collées au rayonnement de lampes de chauffage.

7. Procédé selon la revendication 1, dans lequel le traitement thermique est réalisé dans un four.

8. Procédé selon la revendication 1 dans lequel au moins une des structures est une structure multicouche.

9. Procédé selon la revendication 1, dans lequel avant le collage on prépare la surface d'au moins une des structures pour y pratiquer un relief.

10. Procédé selon la revendication 1, dans lequel, lors du décollage on exerce en outre sur les structures des forces extérieures (240, 241) de séparation.

## Claims

1. Treatment process for bonding two structures (100, 120, 200, 220) by molecular adhesion on a bonding interface (124, 224), and unbonding of the said two structures along the said bonding interface, **characterized in that**:
- bonding is done using at least one of said two structures (100, 200) containing at least one element capable of diffusing within the said structure towards the bonding interface,
- unbonding is done using a heat treatment with a sufficient thermal budget to make the said element diffuse towards the bonding interface (124, 224) to weaken it.

2. Process according to claim 1, in which hydrogen implantation is done in at least one of the structures (100) before bonding, hydrogen forming the said element capable of diffusing within the structure.

3. Process according to claim 2, in which implantation is done in silicon with a dose of between 10¹⁶ and 5.10¹⁶ and an energy of between 20 and 500 keV.

4. Process according to claim 1, in which at least one structure (200) is used comprising a surface oxide layer (206) formed by a Plasma Enhanced Chemical Vapour Deposition and containing OH molecules, the said OH molecules forming the element capable of diffusing.

5. Process according to claim 3, in which the heat treatment is done at a temperature of between 600 and 1350°C.

6. Process according to claim 1, in which the heat treatment is done by exposing the bonded structures to radiation from heating lamps.

7. Process according to claim 1, in which the heat treatment is done in a furnace.

8. Process according to claim 1, in which at least one of the structures is a multi-layer structure.

9. Process according to claim 1, in which the surface of at least one of the structures is prepared before bonding to form a relief on it.

10. Process according to claim 1, in which external separation forces (240, 241) are also exerted on the structures at the time of unbonding.

## Patentansprüche

1. Behandlungsverfahren für das Zusammenkleben von zwei Strukturen (100, 120, 200, 220) durch Molekularklebung gemäß einer Klebungsgrenzfläche (124, 224) und das Voneinanderlösen der beiden genannten Strukturen gemäß der genannten Grenzfläche,
**dadurch gekennzeichnet, dass**:
- man für das Kleben mindestens eine der genannten beiden Strukturen (100, 200) verwendet, die wenigstens ein Element enthält, das in der genannten Struktur in Richtung Klebungsgrenzfläche diffundiert,
- man für das Ablösen eine Wärmebehandlung mit einem Wärmehaushalt durchführt, der ausreicht, um das genannte Element in Richtung Klebungsgrenzfläche (124, 224) diffundieren zu lassen, um diese brüchig zu machen.

2. Verfahren nach Anspruch 1, bei dem man vor dem Kleben in wenigstens einer der Strukturen eine Wasserstoffimplantation (100) durchführt, wobei der Wasserstoff das genannte Element bildet, das in der Struktur diffundiert.

3. Verfahren nach Anspruch 2, bei dem die Implantation in Silicium durchgeführt wird, mit einer zwischen 10¹⁶ und 5.10¹⁶ enthaltenen Dosis und einer zwischen 20 und 500 KeV enthaltenen Energie.

4. Verfahren nach Anspruch 1, bei dem man wenigstens eine Struktur (200) mit einer Oberflächenoxidschicht (206) benutzt, die durch PECVD gebildet wird und OH-Moleküle enthält, wobei diese OH-Moleküle das Diffusionselement sind.

5. Verfahren nach Anspruch 3, bei dem die Wärmebehandlung bei einer zwischen 600 und 1350 °C enthaltenen Temperatur durchgeführt wird.

6. Verfahren nach Anspruch 1, bei dem die Wärmebehandlung durchgeführt wird, indem man die zusammengeklebten Strukturen der Strahlung von Heizlampen aussetzt.

7. Verfahren nach Anspruch 1, bei dem die Wärmebehandlung in einem Ofen stattfindet.

8. Verfahren nach Anspruch 1, bei dem wenigstens eine der Strukturen eine Multischichtstruktur ist.

9. Verfahren nach Anspruch 1, bei dem man vor dem Kleben die Oberfläche von wenigstens einer der Strukturen vorbereitet für die Realisierung eines Reliefs.

10. Verfahren nach Anspruch 1, bei dem man beim Ablösen die Strukturen außerdem äußeren Trennungskräften (240, 241) aussetzt.
